(19) Europäisches Patentamt

European Patent Office

Office européen des brevets

(11) Publication number: 0 165 407
A2

(12) EUROPEAN PATENT APPLICATION

(21) Application number: 85104882.7

(22) Date of filing: 22.04.85

(51) Int. Cl.⁴: G 05 D 7/06
F 16 K 31/02

(30) Priority: 26.04.84 JP 84675/84
18.12.84 JP 192106/84 U

(43) Date of publication of application:
27.12.85 Bulletin 85/52

(84) Designated Contracting States:
AT CH DE FR GB IT LI NL SE

(71) Applicant: NIPPON ENLARGING COLOR INC.
18, Nakano-Cho Ichigaya Shinjuku-Ku
Tokyo(JP)

(72) Inventor: Sato, Toshio
4-8, Taishido 2-Chome Setagaya-Ku
Tokyo(JP)

(72) Inventor: Akashi, Masahiko
5-14, Shinmei 1-Chome
Hino City Tokyo(JP)

(72) Inventor: Iwasaki, Norio
14-22, Shakujii-Cho 4-Chome Nerima-Ku
Tokyo(JP)

(72) Inventor: Suenaga, Taro
7-11, Seta 4-Chome Setagaya-Ku
Tokyo(JP)

(74) Representative: Fleuchaus, Leo, Dipl.-Ing. et al,
Fleuchaus & Wehser Melchiorstrasse 42
D-8000 München 71(DE)

(54) Flow control valve with piero-electric actuator.

Ⓕ A flow control valve comprises a valve chamber having an inlet and an outlet for a fluid to be controlled, a valve seat provided in the valve chamber on a side of the outlet, a valve body provided in the valve chamber and adapted to abut against the valve seat, and driving means including a piezo-electric unit of laminated piezo-electric elements or bimorph type piezo-electric elements deformable in response to voltage applied to the unit so as to drive the valve body toward and away from the valve seat to close and open the valve. According to the invention, the valve body is driven by the driving unit of the piezo-electric elements having high frequency responsibility so as to precisely control the fluid flow in short interval of time. The driving force of the driving means is very strong of the order of several Kg to ensure the positive operation of the control valve so as to increase its reliability. Furthermore, the strong driving force need not provide damping means for a vibration system of the valve and therefore makes simple in construction the control valve itself.

FIG_I
PRIOR ART

TITLE MODIFIED
see front page

## FLOW CONTROL VALVE

This invention relates to a flow control valve, and more particularly to a flow control valve simple in construction and reliable in operation and being able to control flow rate of a fluid such as air with high precision and at high speed.

As one example of devices for controlling fluid flow at high speed and with high precision, there has been an ink sprayer of an ink jet type enlarging multicolor printing device concerned with the business of the applicant of this application disclosed, for example, Japanese Patent Application Publications Nos. 6,533/67 and 21,326/72. With the above enlarging multicolor printing device, images of a literature and picture are optically and two-dimensionally scanned in a manner, for example, in the photo-picture transmission or the scanner for printing reproduction to obtain picture signals representing densities of the images. The picture signals are then converted into amounts of jetted ink from time to time to print the images on a recording medium such as a sheet of paper moving in synchronism with the scanning of the images of the literature.

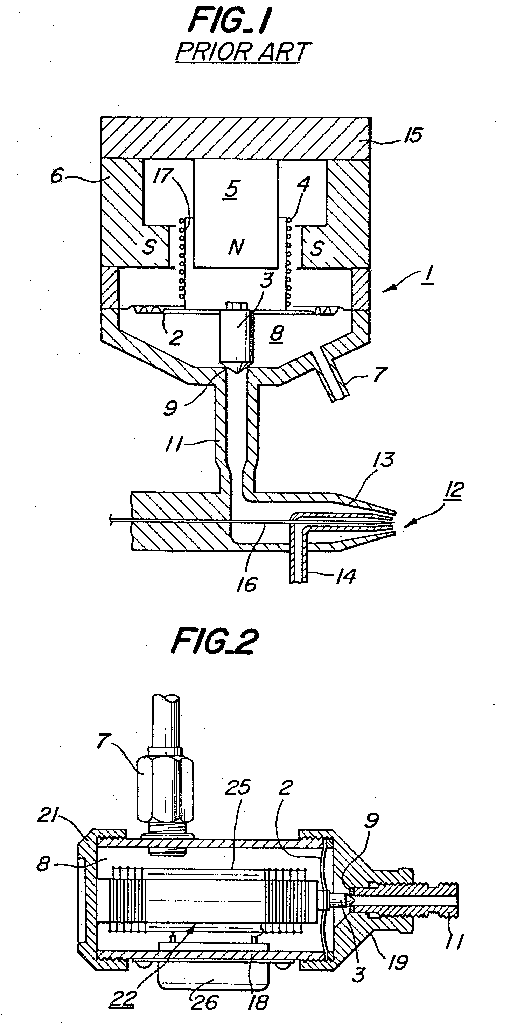

The above ink sprayer is an output device of the enlarging multicolor printing device, which is constructed, for example, as shown in Fig. 1. Referring to Fig. 1, a flow control valve 1 (simply referred to hereinafter as "control valve") for air flow comprises a valve body 3 suspended at a center of a leaf spring 2 in the form of a disc. The valve body 3 is driven in its axial direction by a mutual action of a moving coil 4 integrally arranged on the leaf spring 2 and supplied with electric current correspondingly to the picture signals and an annular magnetic field formed between first and second magnetic poles 5 and 6, so that compressed air introduced from a compressed air source (not shown) through an air supply pipe 7 into a valve chamber 8 is supplied into an ink jet nozzle 12 through an air feeding pipe 11 and an annular clearance between a tip end of the valve body 3 and a valve seat 9, which is variable in response to magnitudes of the picture signals. The ink jet nozzle 12 includes a cylindrical air nozzle 13 and an ink nozzle 14 coaxially arranged in the air nozzle 13 to mix the air in the air nozzle 13 with the ink sucked in the ink nozzle 14 with the aid of the Bernoulli's theorem to form ink mist. Such an operation and theorem for producing the mist will not be explained in more detail, because they have been well known. The control valve 1 shown in Fig. 1 comprises a permanent magnet 15 for producing the magnetic field and a needle valve 16 for adjusting the amount of the ink.

Such a control valve 1 above constructed has been actually used and has fulfilled its aimed function for many years. However, as magnetic force acting on the moving coil 4 is comparatively small, a spring constant of the leaf spring 2 cannot be large and hence a characteristic frequency of a vibration system having an inertia mass consisting of the valve body 3, moving coil 4, bobbin 17 for the coil and the like cannot be large, so that a response frequency of the control valve is at the most hundreds Hz. Even if the moving coil 4 is made as a multiplex winding coil to increase its driving force, the responsibility is not improved due to an increase in inertia.

The fact that the response frequency of the control valve is small means that intervals of the ink mist at the ink jet nozzle 12 cannot be short. As the result, the resolution and sharpness are unavoidably lowered.

Moreover, when the valve body 3 is moved in its axial direction from one position to the other, it would do so-called overshooting unless its movement is effectively damped. Namely, due to the inertia of the vibration system, the valve body 3 will overshoot to cause excessive opening or closing of the control valve. Furthermore, such an overshooting causes the valve body 3 to vibrate in a complicated manner in conjunction with returning function of the leaf spring 2 and rebounding of the valve body 3 due to collision against the valve seat 9. With the control valves actually used, of course, the damping of the vibration system is effected by making small the output impedance

SU2P-2933 EPA

of an amplifier for supplying current to the moving coil, or by electromagnetic braking with the aid of electromotive force caused in the moving coil 4 by the overshooting, or by electrical braking means which is not explained because it is not essential for the invention. However, the overshoot cannot be completely eliminated, so that excessive air flow and ambiguous closing of the valve due to overshooting resulting in variation or unevenness in density of images and lower sharpness.

Furthermore, as the moving stroke of the valve body 3 is very small, for example, 50-100 μ (μ=0.001 mm) so that the flow rate is greatly changed by a slight displacement of the valve body. Accordingly, severe accuracy in working and assembling of the valve body is required. However, its assembling and adjusting are not easy matter because it is resiliently supported by the leaf spring 2 as shown in Fig. 1.

It is therefore an object of the invention to provide an improved flow control valve which is simple in construction and reliable in operation and capable of controlling flow rate of a fluid with high precision and at high speed.

In order to achieve this object, a flow control valve according to the invention comprises a valve chamber having an inlet pipe and an outlet pipe for a fluid to be controlled, a valve seat provided in said valve chamber on a side of the outlet pipe, a valve

SU2P-2933 EPA

body provided in said valve chamber and having one end in opposition to said valve seat, and driving means including a piezo-electric unit deformable in response to voltage applied to the unit so as to drive said valve body toward and away from the valve seat to close and open an opening of said valve seat.

In a preferred embodiment of the invention, the piezo-electric unit comprises a plurality of piezo-electric elements and a plurality of thin electrode plates, these elements and plates being alternately laminated to form a unitary bar-like body, and lead wires connecting every other said electrode plates in parallel for applying simultaneously to all said piezo-electric elements bias voltage for determining a zero point of fluid flow and control voltage in a direction opposite to that of said bias voltage.

In a further embodiment of the invention, the number of said piezo-electric elements is m times as many as $2^n-1$ where m is a positive integral number, one or more, and n is a positive integral number, two or more and equal to the number of bits of binary coded control signals, and said piezo-electric elements are divided into groups whose number is equal to the number of said bits, the number of the piezo-electric elements in one said group being $m \times 2^{i-1}$ where i is an order of the groups, and said lead wires being connected to said element such that the voltage is applicable in parallel to the piezo-electric elements in each said group independently from the other groups in a manner that when all the bits are "0", a zero point of the fluid flow is set and when the bit is "1", the piezo-electric elements in the group corresponding to the bit is driven in a direction opposite to that when the bias voltage is applied.

In a preferred embodiment of the invention, the piezo-electric unit comprises a bimorph type piezo-electric element which is bent when voltage is applied thereto, pivotal means for supporting ends of the piezo-electric element to permit the ends to tilt and a joining unit for connecting said valve body to said piezo-electric element.

According to the invention, the pivotal means comprises guide blocks fitted on ends of said element and having ridges, a U-shaped holder made of a long leaf spring having a pair of perpendicularly bent ends, and receiving blocks formed with V-shaped grooves and fixed to said bent ends of said U-shaped holder so as to receiving said ridges of the guide blocks in the V-shaped grooves in the receiving blocks, thereby permitting the ends of the element to tilt.

The invention will be more fully understood by referring to the following detailed specification and claims taken in connection with the appended drawings.

Fig. 1 is a schematic sectional view illustrating one example of flow control valve of the prior art;

Fig. 2 is a sectional view of a flow control vave of one embodiment of the invention;

Fig. 3 is an exploded perspective view of piezo-electric elements and electrode plates of a driving unit used in the valve shown in Fig. 2;

Fig. 4 is a schematic partial side view of the driving unit illustrating connection of lead wires to the piezo-electric elements;

Fig. 5 is a graph illustrating voltage to be applied the piezo-electric elements;

Fig. 6 is a graph illustrating one example of relation between extention and contraction of piezo-electric elements and voltage to be applied thereto;

Fig. 7 is a schematic side view of the driving unit of another embodiment of the invention illustrating connection of lead wires to the elements;

Fig. 8 is a perspective view of piezo-electric units for constituting a driving unit of a further embodiment of the invention;

Fig. 9 is an enlarged sectional view of the piezo-electric unit shown in Fig. 8;

Fig. 10 is a sectional view of a flow control valve of a further embodiment of the invention;

Fig. 11 is a sectional view of a flow control valve of another embodiment of the invention;

Fig. 12 is a perspective view of the valve shown in Fig. 11;

Fig. 13 is a perspective view illustrating a constitution of a bimorph type piezo-electric element;

Fig. 14 is a composite graph of a graph illustrating voltage to be applied to a driving plate, a graph illustrating the voltage and deformation of the driving plate and a graph illustrating opening of the valve;

Fig. 15 is a view illustrating deformation of the bimorph type piezo-electric element;

Fig. 16 is a partial perspective view of one embodiment of pivotal means for the driving plate according to the invention;

Fig. 17 is a partial perspective view of another embodiment of pivotal means; and

Fig. 18 is a perspective view of one embodiment of connection between the valve body and the driving plate according to the invention.

Referring to Fig. 2, a flow control valve according to the invention comprises a valve casing 18 in the form of a metal cylinder having at one end (on a right end in Fig. 2) a front cap 19 and at the other end a rear cap 21 hermetically threadedly engaged thereon, respectively, to form a valve chamber 8 therein.

To the valve chamber are connected an air supply pipe 7 as an inlet pipe for a controlled fluid (compressed air in this embodiment) and an air feed pipe 11 as an outlet pipe. In the embodiment shown in Fig. 2, the air feed pipe 11 passes through the front cap 19 and is coaxially and hermetically threadedly engaged therewith and formed with an annular valve seat 9 at an inner end facing to an inside of the valve chamber 8.

A valve body 3 having a conical end is arranged in the proximity of the valve seat 9 with a tip end of the valve body 3 in opposition to an opening of the valve seat 9. The valve body 3 is supported at its center by a leaf spring 2 and its bottom portion integrally and tightly jointed to a driving unit 22.

The leaf spring 2 is for example, a circular elastic plate covering an opening of the valve casing and is circumferentially or radially formed with at least one slit (not shown) to enable the compressed air flowed through the air supply pipe 7 into the valve chamber 8 to flow into the air feed pipe 11. Moreover, the leaf spring 2 is provided to facilitate the alignment of the valve body 3 with the valve seat 9 and can be dispensed because it is not essential for the invention.

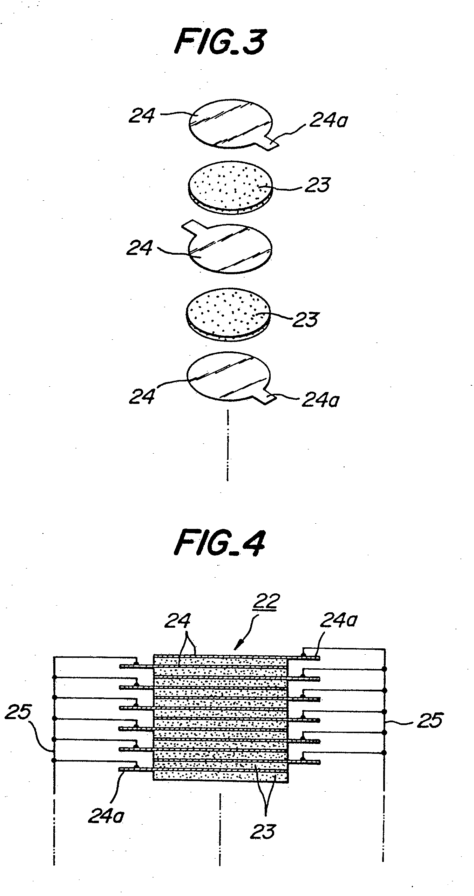

As shown in Figs. 3 and 4, the driving unit 22 comprises a plurality of piezo-electric elements 23 in the form of circular discs and a plurality of thin electrode plates 24 similar in shape to the elements 23 alternately laminated and integrally jointed by means of a conductive adhesive to form a bar-like body. As shown in Fig. 2, to one end (right end viewed in Fig. 2) of the driving unit 22 is attached the valve body 3 for example by an adhesive. The other end of the driving unit 22 is coaxially attached to an inner surface of the rear cap 21 forming an inner wall of the valve chamber 8.

A material of the piezo-electric elements 23 is preferably a sintered ceramic material having the piezo-electric effect, for example, PZT (zircon titanate) and barium titanate used as ultrasonic wave oscillator elements.

Each the electrode plate 24 is provided at its outer periphery with a connection piece 24a. The electrode plates 24 are arranged between the piezo-electric elements 23 so as to arrange the connection pieces 24a alternately extending in opposite directions as shown in Fig. 4. In this manner, the connection pieces 24a are arranged in two rows along generation lines of the driving unit 22 and in symmetry with its axis and electrically connected to a pair of common lead wires 25 as shown in Fig. 4. These lead wires 25 are introduced through a connector 26 arranged on the valve casing 18 (Fig. 2) out of the valve chamber 8 and connected through an amplifier (not shown) to, for example, a control signal source (not shown) for a printing device. With this arrangement, the control voltage from the above control signal source is applied in parallel to the piezo-electric elements 23 constituting the driving unit 22. The driving unit 22 may be coated with a soft synthetic resin for the purpose of reinforcement of it, because the resistance of the synthetic resin is slight in comparison with the force caused when the voltage is applied to the piezo-electric elements as explained hereinafter.

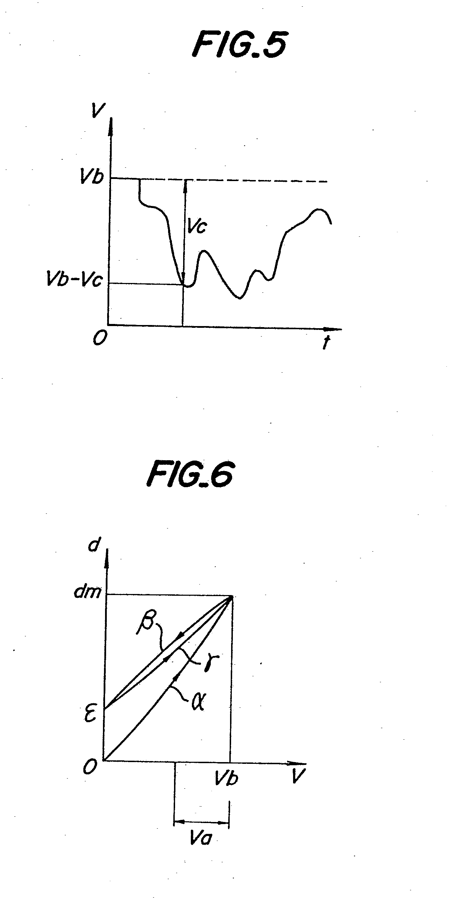

The control valve constructed as above described according to the invention is used in a manner that a constant positive bias voltage $V_b$ plus a negative control voltage $V_c$ variable with time, that is, $V_b - V_c$ is applied to the groups of piezo-electric elements 23 of the driving unit as shown in Fig. 5. It is of course understood that for example the control voltage $V_c$ is in proportion to the picture signals obtained in scanning the images of the literature and picture in the enlarging multicolor printing device initially mentioned. In this case, the positive voltage means the voltage having a direction for extending the driving unit, while the negative voltage means the voltage having the direction opposite to that of the positive voltage. It is of course that a large voltage is previously applied to the piezo-electric elements 23 of the driving unit to align directions of polarization of their crystal grains with directions of their thickness.

An absolute value of the above bias voltage $V_b$ is so set that when the control voltage $V_c$ is zero or is applied in parallel to all the piezo-electric elements 23 constituting the driving unit, the valve body 3 (Fig. 2) closes the opening of the valve seat 9 that is, the flow rate of the compressed air being zero according to the material and thickness and the number of the piezo-electric elements in the driving unit. The expression that the valve body 3 closes the opening of the valve seat 9 used herein means the condition that the ink is not jetted from the ink nozzle 12 (Fig. 1) including the condition of the tip end of the valve body 3 abutting against the valve seat 9, even if a small amount of compressed air is leaking at the opening of the valve seat 9.

On the other hand, when the positive voltage to be applied to the piezo-electric elements 23 is progressively increased, the extending distance d of the driving unit 22 increases along a curve $\alpha$ to the maximum set extending distance $d_m$ at the bias voltage $V_b$, if the charged amount of the dielectric piezo-electric elements 23 is zero as shown in Fig. 6. Thereafter, when the voltage V is decreased, the extending distance d is progressively decreased along a curve $\beta$ which is substantially straight to a strain $\varepsilon$ where the voltage is zero. Furthermore, when the voltage V is again increased, the extending distance d of the driving unit increases along a curve $\gamma$ starting from the strain $\varepsilon$ which is also substantially straight and close to the curve $\beta$ to the maximum set extending distance $d_m$ at the applied bias voltage $V_b$. At this stage, even if the voltage to be applied to the piezo-electric elements 23 varies dependently on the control voltage $V_c$, the voltage applied to the elements 23 does not exceed the bias voltage $V_b$, so that the extending distance d varies linarly from the maximum distance dm to smaller values. In other words, the clearance between the valve body 3 (Fig. 2) and the valve seat 9 varies in porportion to the control voltage $V_c$, while the amount of the compressed air jetted from the air feed pipe 11 (Fig. 1) is in proportion to the clearance. Therefore, the amount of the ink jetted from the ink nozzle 12 is in proportion to the picture signals.

Even if the amounts of extension and contraction of each the piezo-electric element 23 is very small of the order of μ (micron), the stroke of the order of 100 μ of the valve body for the control valve can be easily obtained by the laminated piezo-electric elements 23.

Moreover, the piezo-electric elements have characteristics capable of precisely controlling their extension and contraction so as to enable the extension and contraction of the driving unit 22 to be controlled with a high accuracy in the order of 0.01 μ. Furthermore, the frequency responsibility of the piezo-electric elements is very high such as 50 to several hundreds kHz which can be understood from the fact that they are used as ultrasonic wave oscillator elements.

In addition thereto, the driving force of the driving unit 22 is very large such as several tens to several hundreds Kg so as to drive the valve body 3 easily.

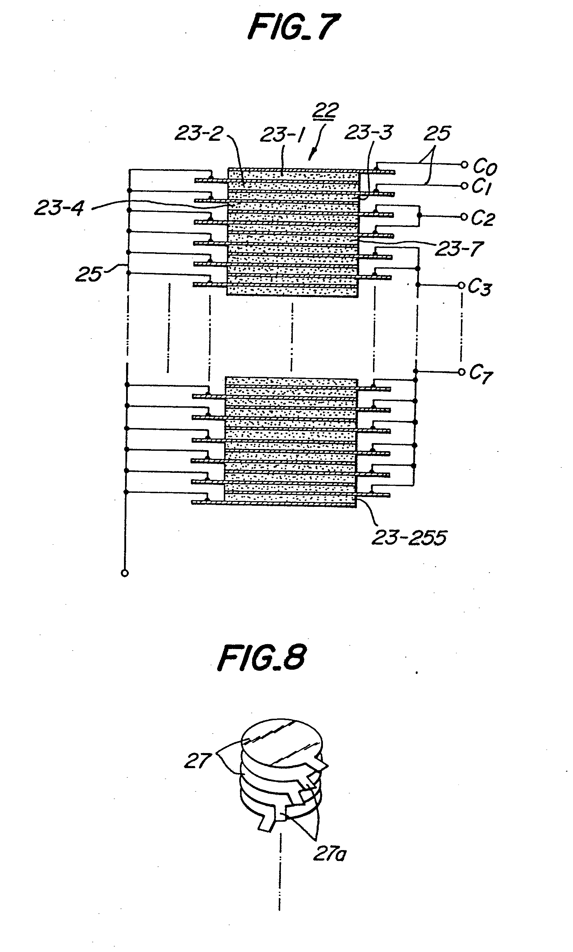

Fig. 7 illustrates a driving unit 22 of a control valve of another embodiment of the invention, which drives a valve body with the aid of binary-coded control signals.

In applying this control valve to, for example, the above enlarging multicolor printing device, picture signals as analog signals outputted from the image scanning system from time to time are sampled with constant short periods of intervals to obtain sampled signals which are converted into, for example, binary-coded control signals $C_0$, $C_1$, $C_2$, $\cdots$, $C_7$ consisting of 8 bits by the use of an analog to digital converter (not shown). These digital control signals of 8 bits are discontinuous signals of 256 kinds from 0 to 255. In enlarging multicolor printing device, if the density of images can be divided into 256 grades, the density can be sufficiently deemed as continuous. Moreover, the number of the bits of the above digital control signals can be increased or decreased if required.

As shown in Fig. 7, on the other hand, piezo-electric elements 23 m times as many as $2^n-1$ (m is a positive integral number, one or more) are laminated alternately with electrode plates 24 in the same manner as in the first embodiment according to the number n (n=8 in the shown embodiment) of the bits of the digital control signals. In this embodiment shown in Fig. 7, the piezo-electric elements in the driving unit 22 are 255 because m is 1 (one) for the sake of clarity of the drawing.

Moreover, these 255 piezo-electric elements 23 are divided into 8 groups, 1st to 8th groups the same as the number of bits of the digital control signals, wherein the number of the piezo-electric elements of ith group (where i=1, 2, $\cdots$, 8) is $m \times 2^{i-1} = 2^{i-1}$. As shown in Fig. 7, in other words, the uppermost piezo-electric element 23-1 is in 1st group, two next piezo-electric elements 23-2 and 23-3 are in 2nd group, four next piezo-electric elements 23-4 to 23-7 are 3rd group, $\cdots$ elements 23-128 to 23-255 are 8th group. Lead wires 25 are connected to the elements such that the voltage is applied in parallel to the piezo-electric elements in one group independently from the other groups.

The 1st to 8th groups of the elements are made corresponding to digital control signals $C_0$-$C_7$, respectively. A constant negative voltage $V_a$ whose absolute value is less than $V_b$ is applied in parallel to the piezo-electric elements, when the bit is "1" according to whether it is "0" or "1" (Fig. 6). Moreover, the groups are so set that the driving unit extends the maximum distance to the zero flow rate position to close the opening of the valve seat, when the above bias voltage $V_b$ is permanently applied in parallel to all the piezo-electric elements of the driving unit 22 and the respective bits of the digital control signals C are "0". Furthermore, the values of the constant negative control voltage $V_a$ is so set that the driving unit 22 contracts to the minimum length to open the annular clearance between the valve body 3 (Fig. 2) and the valve seat 9 when the negative voltage $V_a$ is applied to all the piezo-electric elements of the driving unit 22 or all the bits of the digital control signals C are "1".

The control valve equipped with the driving unit shown in Fig. 7 according to the invention is substantially the same as that shown in Fig. 2 with the exception that lead wires 25 are somewhat modified. Therefore, the control valve will not be explained and illustrated in more detail.

The control valve of this embodiment samples picture signals several thousands per one second to convert the sampled signals into digital control signals $C_0$-$C_7$ of 8 bits by an analog to digital converter. The digital signals are then supplied to the corresponding groups of the piezo-electric elements through amplifiers, thereby applying the negative voltage $V_a$ whose absolute value is less than that of the positive bias voltage $V_b$ as shown in Fig. 7. The time for applying the voltage $V_a$ is usually determined so as to be substantially the same time intervals for the sampling.

With this arrangement, the negative voltage $V_a$ is applied to the piezo-electric elements 23 of binary-coded numbers represented by the control signals C, with the result that the clearance between the valve seat and the valve body and the amount of the compressed air leaked from the valve chamber 8 increase or decrease in proportion to the control signals, so that the amount of the ink jetted from the ink nozzle 12 (Fig. 1) varies linearly with the control signals C which is proportional to picture signals.

Referring to Fig. 8 illustrating a further embodiment of the invention, a plurality of thin piezo-electric units 27 constructed as mentioned later are laminated so as to angularly shift electrode plates about their axes little by little to from a driving unit 22. In Fig. 8, distances between the piezo-electric units 27 are exaggeratedly shown for the sake of clarity.

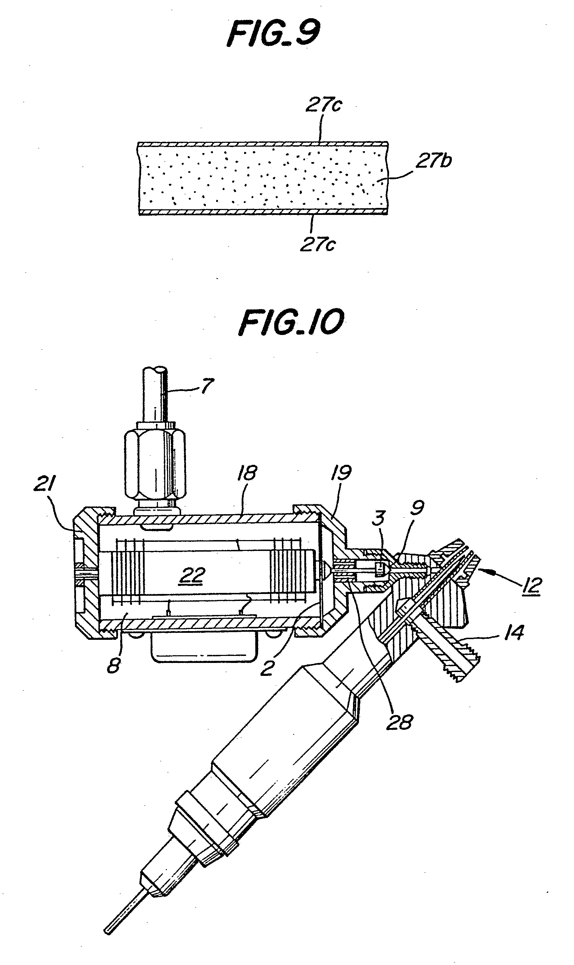

In forming the piezo-electric unit 27, a crystalline piezo-electric material is pulverized and kneaded with, for example, an organic paste, and the material with the paste is extended in a thickness, for example, several tens to several hundreds μ to form a piezo-electric sheet 27b as shown in Fig. 9. Electrode films of, for example, silver-palladium alloy are printed on both surfaces of the piezo-electric sheet 27b to form a composite unit which is punched to obtain discs having connection pieces 27a extending therefrom.

These piezo-electric units 27 are laminated into a cylindrical shape having connection pieces 27a spirally extending as shown in Fig. 8 and the laminated units are sintered to form the driving unit 22.

As well known, the narrower the distances between the electrodes of the piezo-electric elements, the lower is the voltage for causing the piezo-electric effect. However, when the distances between the electrodes become smaller, it becomes difficult to connect lead wires 25 to the connection pieces 24a as can be seen from Figs. 4 and 7. In contrast herewith, according to the embodiment shown in Fig. 8, the connection pieces 27a are spirally arranged to facilitate the connection of the lead wires 25 to the connection pieces 27a.

Referring to Fig. 10 illustrating another embodiment of the invention, a valve body 3 is elongated and a valve closing and opening portion consisting of a valve seat 9 and a valve body 3 is arranged in the proximity of an ink jetting opening of an ink nozzle 12 (Fig. 1). In this embodiment, moreover, a center portion of the valve body 3 is supported by a sleeve 28 made of for example slippery Teflon in order to prevent the valve body 3 from swinging.

As shown in Fig. 10, as the valve closing and opening portion is arranged in the proximity of the ink jetting opening of the ink nozzle 12, a volume of an air flow passage from the valve closing and opening portion to the ink jetting opening becomes small, whereby the amount of the jetted ink precisely follows the control signals to make sharp the obtained images. Namely, if the volume of the air flow passage from the valve closing and opening portion to the ink jetting opening is large as shown in Fig. 1, the pressure of the compressed air delivered from the valve closing and opening portion into the passage progressively increases to the maximum pressure when for example the valve is opened from a completely closed condition, so that the air flow at the ink jetting opening progressively increases without rapidly increasing. As the result, edges of the images obtained from original images having sharp edges are blurred to lower the sharpness of the images. In contrast herewith, the control valve shown in Fig. 10 eliminate such a disadvantage to make sharp images.

Although the elongated valve body 3 as shown in Fig. 10 increases an inertia resistance and a frictional resistance is caused due to the sleeve 28, these resistances are negligible small for the driving unit 22 having the strong driving force owing to the piezo-electric effect according to the invention. In other words, the arrangement shown in Fig. 10 can be realized only by the control valve utilizing the piezo-electric effect according to the invention.

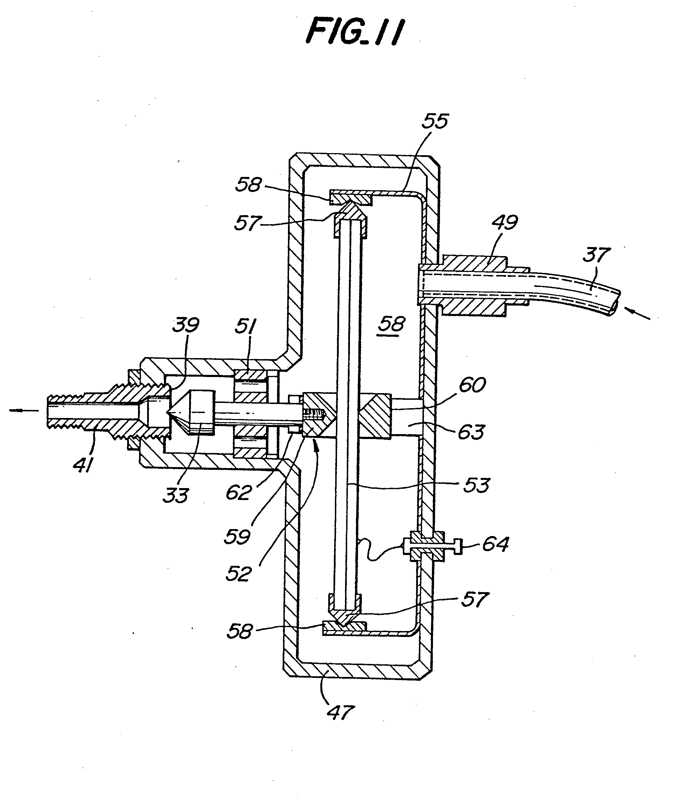

Referrng to Fig. 11 illustrating a further embodiment of the invention, a valve casing 48 consists of two different volume portions and is closed at its ends to form an air-tight valve chamber 38 therein.

To the valve chamber 38 are connected an air supply pipe 37 as an inlet pipe for a controlled fluid (compressed air in this embodiment) and an air feed pipe 41 as an outlet pipe. In the embodiment shown in Fig. 11, the air supply pipe 37 is connected to the valve casing through a fitting 49 passing through one end plate of the valve casing 48 (on the right side of Fig. 11). The air feed pipe 41 passes through the other end plate of the valve casing 48 and is threadedly engaged therein coaxially to a center axis of the valve casing in an air-tight manner. The air feed pipe 41 is formed with an annular valve seat 39 at its inner end facing to the valve chamber 38.

A valve body 33 having a conical end is arranged in the proximity of the valve seat 39 with the conical end in opposition to an opening of the valve seat 39. The valve body 33 is slidably supported at its center portion in a sleeve 21 fitted in the valve casing and is integrally jointed at its inner end through a joining unit 52 with a driving plate 53 which is a so-called bimorph type piezo-electric element (Fig. 12).

As shown in Figs. 11 and 12, the sleeve 51 is a thick disc made of a material having a small coefficient of friction, such as Teflon and is formed in its axis with a bore (no reference number) for fitting the valve body 3 therein and in the proximity of the bore with at least one vent hole 54 in parallel with the bore and passing through the sleeve 51 for permitting the air flowed through the air supply pipe 37 into the valve chamber 38 to flow into the air feed pipe 41.

On the other hand, a U-shaped holder 55 made of a long leaf spring having a pair of perpendicularly bent ends is fixed to an inside of the end plate of the valve casing 48. The driving plate 53 is elastically held between the pair of bent ends of the U-shaped holder 55.

The driving plate 53 is bent or curved when voltage is applied thereto in its thickness direction because it is the bimorph type piezo-electric element as above mentioned. A material of the piezo-electric element is preferably a ceramic material, for example, PZT (zircon titanate) and barium titanate used as ultrasonic wave oscillator elements. A ceramic material having the piezo-electric effect is sintered to form long plates which are then attached to each other, for example, by a conductive adhesive to obtain the driving plate 53.

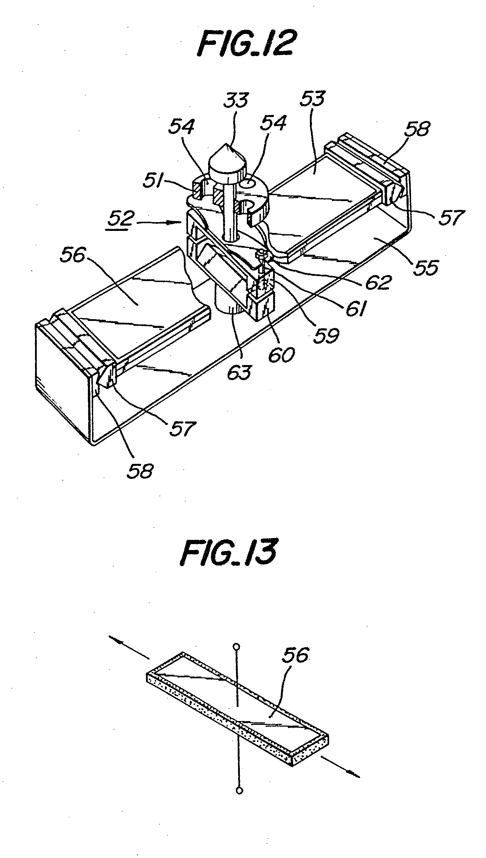

When voltage is applied to a piezo-electric element through electrodes 56 printed thereon in its thickness directions as shown in Fig. 13, the piezo-electric element extends or contracts in its lengthwise directions shown by arrows in Fig. 13. Two these piezo-electric elements are attached to each other such that the extension and contraction of these elements are in opposite directions when electric voltage is applied to the elements, thereby obtaining the bimorph type piezo-electric element adapted to be curved or bent when applying the voltage. As such bimorph type piezo-electric elements are available in the market, they will not be explained in further detail herein.

The driving plate 63 is provided at its ends with guide blocks 57 integrally therewith as shown in Figs. 11 and 12. Each the guide block 57 is a V-shaped rod formed with a groove for tightly fitting therein the end of the driving plate 53 (Fig. 11).

On the other hand, to each the bent end of the U-shaped holder 55 is fixed a receiving block 58 in the form of a rod formed with a V-shaped groove for engaging and receiving a ridge of the guide block 57. With this arrangement, the driving plate 53 is supported so as to permit its ends to be tilted in a plane of Fig. 11. Moreover, a distance between the bent ends of the U-shaped holder 55 under a free condition is set a somewhat smaller than that when the driving plate is supported therein as shown in Figs. 11 and 12, so that the guide blocks 57 and the receiving blocks 58 are resiliently engaged with each other without any play therebetween.

On the other hand, the joining unit 52 for connecting the valve body 33 to the driving plate 53 is constructed as follows.

As shown in Figs. 11 and 12, the joining unit 52 comprises a first support 59 and a second support 60. Each the support 59 or 60 is a rod extending in a width direction of the driving plate 53 and formed with a ridge having an isosceles triangular cross-section in opposition to the driving plate 53. The first and second supports are kept in parallel with each other and embrace a center of the driving plate 53.

As shown in Fig. 12, moreover, the second support 60 is provided at its ends with guide rods 61 on a surface of the support 60 facing to the other support 59. Each the guide rod 61 is perpendicularly planted in the surface of the support 60 and is formed at its end with male screw-threads (not shown). The first support 59 is formed with guide apertures (no reference numerals) passing therethrough for sidably fitted therein the guide rods 61 such that their threaded ends extend beyond the first support 59.

On the other hand, the valve body 33 is located at the center of an upper surface of the first support 59 as viewed in Fig. 12. A V-shaped leaf spring 62 is provided on the first support 59 and is formed at its center with an opening adapted to loosely fitted with a stem of the valve body 33 and at both the ends with notches adapted to engage the ends of the guide rods 61 as shown in Fig. 12. Moreover, both the ends of the leaf spring 62 are adapted to engage nuts threadedly engaged with the ends of the guide rods 61.

As the result, as can be seen from Fig. 12, the first and second supports 59 and 60 are urged toward each other by the resilience of the leaf spring 62, so that the valve body 33 is attached to the center of the driving plate 53 through the first and second supports which are in line contact with the

0165407

driving plate. A damper 63 made of, for example, silicon rubber or neoprene is provided to connect between the second support 60 and the U-shaped holder 55, although the damper 63 is not essential for the invention. This damper 63 serves to rapidly damp the resonance determined by inertia masses of the valve body 33, the joining unit 52 and the like and the material, dimension and the like of the driving plate 53. If the resonance frequency is higher than the maximum frequency of images required for the control valve, such a damper 63 is not needed.

A reference numeral 64 in Fig. 11 denotes a terminal for a lead line for applying voltage to the driving plate 54.

The control valve constructed as above described according to the invention is used in a manner that a constant positive bias voltage $V_b$ plus negative control voltage $V_c$ variable with time, that is, $V_b$-$V_c$ is applied to the driving plate 53 as shown in Fig. 14. It is understood that for example the control voltage $V_c$ is in proportion to the picture signals obtained in scanning the images of the literature and picture in the enlarging multicolor printing device.

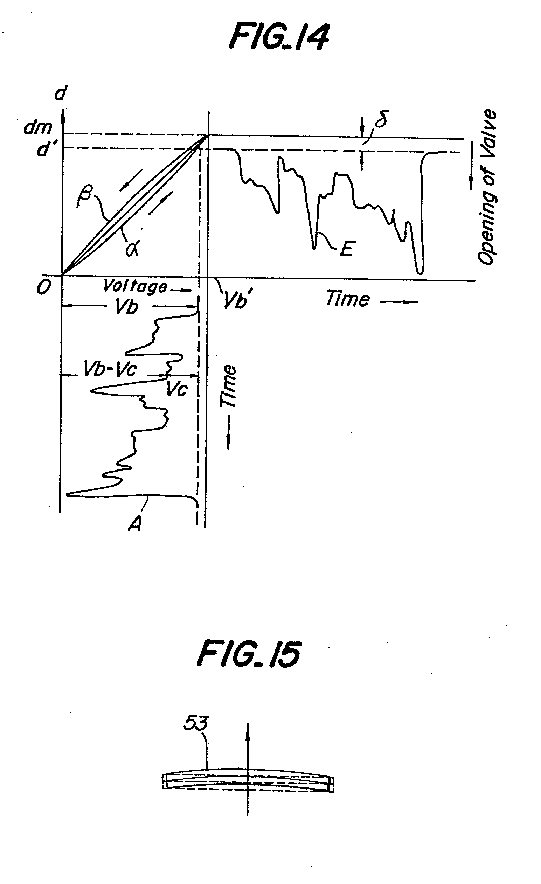

In this case, the above positive voltage is difined in the following manner. As well known, when electric voltage is applied to a bimorph type piezo-electric element, the element is deformed so as to be curved or bent as shown in Fig. 15. As the both ends of the driving plate 53 as a bimorph type piezo-electric element are tiltably suported by the support means in the form of knife edges in the control valve of the embodiment shown in Figs. 11 and 12, the driving plate 53 easily deforms without any obstruction as shown in Fig. 15 so as to move the valve body 33 secured to the center of the driving plate 53 with the jointing unit 52 in the axial direction of the valve body to control the annular clearance or the opening of the control valve between the valve seat 9 (Fig. 11) and the valve body 33. In this case, the positive voltage means that for moving the valve body 33 toward the valve seat 39, while the negative voltage means that having the direction opposite to that of the positive voltage.

The setting of the absolute valve of the bias voltage $V_b$ is effected in the same manner as in the embodiment shown in Fig. 2. The closing of the opening of the valve seat is defined in the same manner as in Fig. 2.

The variation in extending distance of the driving unit by applying the voltage to the piezo-electric elements has been explained by referring to Fig. 6. The same holds true in the embodiment using the driving plate 53 of the bimorph type piezo-electric elements. In this case, the voltage is applied to the driving plate 53 instead of the piezo-electric element 23.

In the embodiment shown in Figs. 11 and 12, respective parameters are so set that the valve body 33 abuts against the valve seat 39 to completely close the opening of the valve seat 39 when the deformation of the driving plate 53 becomes the maximum set value dm. However, the bias voltage $V_b$ is set at a value somewhat lower than the voltage $V_b'$ corresponding to the maximum set value dm as shown in Fig. 14, so that even if the control voltage is zero, the clearance between the valve body and the valve seat is kept opened slightly as shown δ in Fig. 14 so as to leak a small amount of compressed air. This improves the responsibility of the control valve to the variation in control signal. It is of course that the amount of the air leaked from the valve should be set so as not to jet the ink out of the ink nozzle 12 (Fig. 1). In Fig. 14, the hysteresis curve α of initial voltage application is neglected and the remaining strain ε is set at an origin O of the coordinates.

As can be seen from Fig. 14, when the voltage to be applied to the driving plate 53 is varied with the variation in the control voltage $V_c$, the applied voltage does not exceed the bias voltage $V_b$, so that the displacement d of the driving plate 53 to be converted to the movement of the valve body 33 linearly changes to smaller values starting from the deformation d' corresponding to the opening δ of the valve. In other words, the clearance between the valve body 33 and the valve seat 39 varies in proportion to the control voltage $V_c$, while the amount of the compressed air jetted from the air feed pipe 41 (Fig. 11) is in proportion to the clearance. Therefore, the amount of the ink jetted from the ink nozzle 12 (Fig. 1) is in proportion to the picture signals.

The bimorph type piezo-electric elements exhibit comparatively large deformations in comparison with so-called laminated type piezo-electric elements consisting of a number of laminated piezo-electric elements variable in thickness when applying voltage thereto, so that the stroke of the order of 100 μ of the valve body for the control valve can be easily obtained by the bimorph type elements. Moreover, the driving force of the bimorph element is very large such as several Kg in comparison with that of the hitherto used moving coil so as to easily drive the valve body 33 and the joining unit integral therewith.

Moreover, the driving plate 23 as a piezo-electric element has characteristics capable of precisely controlling their deformations so as to control the valve body 33 integrally jointed to the driving plate 53 with a high accuracy of the order of 0.1 μ. Furthermore, the frequency responsibility of the bimorph elements is very high such as 20 to several hundreds kHz which can be understood from the fact that they are used as ultrasonic wave oscillator elements.

Moreover, assuming that the length of the driving plate 53 is several tens mm, the variation in dimension of the driving plate in its length direction is the most several μ when deformations of the driving plate to be converted to the movement of the valve body 33 is 100 μ.

Referring to Fig. 16 illustrating a further embodiment of the invention, ends of a driving plate 53 are tiltably supported by support members in the form of hinges. In Fig. 16, a reference numeral 65 denotes a support having a U-shaped cross-section in which each end of the driving plate is fitted. In this manner, the supports 65 are integrally jointed to the driving plate 53 at its ends. A support shaft 66 is integrally jointed to a surface of the support 65 opposite to the driving plate 53 for example by welding. A U-shaped holder 55 has bent ends which rotatably support the support shafts 66, respectively.

With the arrangement shown in Fig. 16, when voltage is applied to the driving plate 53 to deform it, the support shafts 66 are rotated in the bent ends of the holder 55 to permit the ends of the driving plate 53 to tilt. In this manner, the driving plate 53 can be supported without any interference when it is being deformed as in the embodiment shown in Figs. 11 and 12.

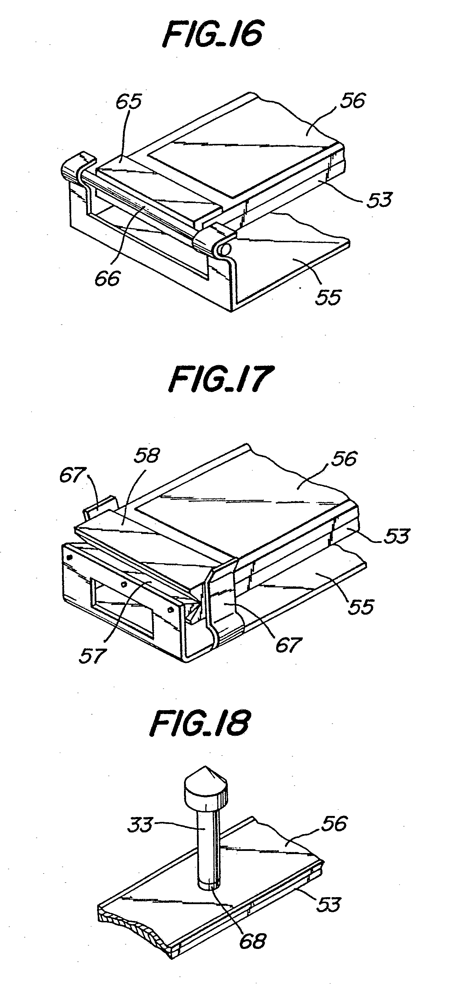

Fig. 17 illustrates a further modification of the embodiment according to the invention. Different from the embodiment shown in Figs. 11 and 12, guide blocks 57 are provided on bent ends of a holder 55, and receiving blocks 58 are provided on both ends of a driving plate 53. Moreover, the holder 55 is formed at its each end with a pair of support pieces 67 integral therewith to embrace the receiving blocks 58. In addition to the effects of the embodiment shown in Figs. 11 and 12, the pairs of support pieces 67 effectively prevent the driving plates 53 from being shifted relative to the holder 55.

Referring to Fig. 18 illustrating a further modification of the invention, a valve body 33 and a driving plate 53 are connected by a connecting plate 68 which is a thin rubber plate having a comparatively high hardness with the aid of an adhesive between the valve body 33 and the driving plate 53 respectively and the connecting plate 68. In the embodiment shown in Fig. 18, the deformation of the driving plate when curved is somewhat absorbed by an elastic deformation of the connecting plate 68 to keep stably the connection between the valve body 33 and the driving plate 53. In addition to the effects of the embodiment shown in Figs. 11 and 12, this embodiment is simple in construction without a joining unit 52 and achieves decrease in inertia resistance.

As can be seen the above description, according to the invention the valve body is driven by the driving unit made of laminated piezo-electric elements or bimorph type piezo-electric elements having high frequency responsibility so as to control the fluid flow in short interval of time. Therefore, the control valve according to the invention is applicable to the above mentioned enlarging multicolor printing device to greatly improve resolution and sharpness of obtained images.

According to the invention, the opening of the valve or the fluid flow to be controlled can be precisely controlled because of high responsibility between the control voltage to be applied and extension and contraction of the driving unit or between the control voltage and the deformation of the driving plate. Therefore, the density and gradation of original images can be reproduced in high fidelity with the above enlarging multicolor printing device.

Moreover, the driving force of the driving unit is very strong of the order of several Kg to ensure the positive operation of the control valve so as to increase its reliability. Furthermore, such a strong driving force need not provide damping means for the vibration system of the valve and therefore makes simple in construction the control valve itself, control circuit and power source therefor and the like.

According to the invention, the constant bias voltage is applied to all the piezo-electric elements or the driving plate to close the control valve completely and the control voltage is applied in the direction decreasing the bias voltage, so that the hysteresis characteristics (Fig. 6) of the extension and contraction of the piezo-electric elements or the deformation of the driving plate relative to the applied voltages can be rationaly utilized.

Although the fluid to be controlled is the air in the embodiments, it is of course possible to use any other fluids other than the air.

In the above explanation, the control signal voltage and the bias voltage for positioning the zero flow point are applied in parallel to the piezo-electric elements. However, voltage multiplied by the number of the laminated piezo-electric elements may be applied in series to ends of the elements or to respective groups of the elements corresponding to bits of binary coded control signals. With this arrangement, terminals of the driving unit can be easily constructed although a high voltage bias power source and control signal output amplifiers are needed.

While the invention has been particularly shown and described with reference to preferred embodiments thereof, it will be understood by those skilled in the art that the foregoing and other changes in form and details can be made therein without departing from the spirit and scope of the invention.

SU2P-2933 EPA

0165407

CLAIMS

1.   A flow control valve comprising a valve chamber having an inlet pipe and an outlet pipe for a fluid to be controlled, a valve seat provided in said valve chamber on a side of the outlet pipe, a valve body provided in said valve chamber and having one end in opposition to said valve seat, and driving means including a piezo-electric unit deformable in response to voltage applied to the unit so as to drive said valve body toward and away from the valve seat to close and open an opening of said valve seat.

2.   A flow control valve as set forth in claim 1, wherein said piezo-electric unit comprises a plurality of piezo-electric elements and a plurality of thin electrode plates, these elements and plates being alternately laminated to form a unitary bar-like body, and lead wires connecting every other said electrode plates in parallel for applying simultaneously to all said piezo-electric elements bias voltage for determining a zero point of fluid flow and control voltage in a direction opposite to that of said bias voltage.

3.   A flow control valve as set forth in claim 2, wherein said piezo-electric elements are in the form of circular discs and the electrode plates are thin circular discs each having at its outer periphery a connection piece integrally formed therewith.

4. A flow control valve as set forth in claim 2, wherein the number of said piezo-electric elements is m times as many as $2^n-1$ where m is a positive integral number, one or more, and n is a positive integral number, two or more and equal to the number of bits of binary coded control signals, and said piezo-electric elements are divided into groups whose number is equal to the number of said bits, the number of the piezo-electric elements in one said group being $m \times 2^{i-1}$ where i is an order of the groups, and said lead wires being connected to said element such that the voltage is applicable in parallel to the piezo-electric elements in each said group independently from the other groups in a manner that when all the bits are "0", a zero point of the fluid flow is set and when the bit is "1", the piezo-electric elements in the group corresponding to the bit is driven in a direction opposite to that when the bias voltage is applied.

5. A flow control valve as set forth in claim 3, wherein said electrode plates are arranged so as to angularly shift about their axes little by little, so that said connection pieces extending spirally about said unitary bar-like body.

6.    A flow control valve as set forth in claim 2, wherein said piezo-electric unit is made by steps of pulverizing a crystalline piezo-electric material, kneading the pulverized material with a paste, extending the kneaded material to form a piezo-electric sheet, printing electrode films on both surfaces of said piezo-electric sheet to form a composite unit, punching the composite unit to obtain discs having said connection pieces and then sintering the discs.

7.    A flow control valve as set forth in claim 1, wherein said valve body is elongated as long as possible and supported in a sleeve to prevent the valve body from swinging.

8.    A flow control valve as set forth in claim 1, wherein said piezo-electric unit comprises a bimorph type piezo-electric element which is bent when voltage is applied thereto, pivotal means for supporting ends of the piezo-electric element to permit the ends to tilt and a joining unit for connecting said valve body to said piezo-electric element.

9.    A flow control valve as set forth in claim 8, wherein said pivotal means comprises guide blocks fitted on ends of said element and having ridges, a U-shaped holder made of a long leaf spring having a pair of perpendicularly bent ends, and receiving blocks formed with V-shaped grooves and fixed to said bent ends of said U-shaped holder so as to receiving said ridges of the guide blocks in the V-shaped grooves in the receiving blocks, thereby permitting the ends of the element to tilt.

10.    A flow control valve as set forth in claim 8, wherein said joining unit comprises first and second supports located on both sides of the piezo-electric element and embracing a center of the element, one of said supports carrying said valve body, and resilient means for resiliently urging said first and second supports to said center of the element.

11.    A flow control valve as set forth in claim 10, wherein said resilient means comprises a V-shaped leaf spring whose center portion engages one of said supports and whose ends engage guide rods slidably passing through said one of the supports and planted in the other of said supports.

12.    A flow control valve as set forth in claim 10, wherein a damper is provided between said U-shaped holder and one of said first and second supports on the side of the U-shaped holder.

13.    A flow control valve as set forth in claim 8, wherein said pivotal means comprises supports each having a V-shaped cross-section in which each end of said driving plate is fitted, support shafts each integrally jointed to a surface of said support opposite to the driving plate, and a U-shaped holder having bent ends each rotatably supporting said support shaft.

14.    A flow control valve as set forth in claim 8, wherein said pivotal means comprises receiving blocks each fitted on one end of said element and formed with a V-shaped groove on opposite side of the element, and a U-shaped holder having two pair of support pieces integral therewith to embrace said guide blocks and bent ends each having a guide block formed with a ridge engaging said V-shaped groove of said receiving block.

15.    A flow control valve as set forth in claim 8, wherein said valve body and said bimorph type piezo-electric element are connected through a damper plate.

SU2P-2933 EPA

# FIG.1
## PRIOR ART

15

6

17

5

4

N

S

S

3

1

2

8

9

7

11

13

12

16

14

# FIG.2

7

25

2

21

9

8

11

19

3

22

26

18

## FIG.3

## FIG.4

SUZP-2933 EPA
0165407

## FIG.5

## FIG.6

# FIG.7

# FIG.8

SU2P-2333 EPA
0165497

## FIG.9

27c

27b

27c

## FIG.IO

7

21

18

19

3

9

22

12

8

2

14

28

# FIG.11

7/9

**FIG.12**

**FIG.13**

SU2P-2933 EPA
0165407

## FIG.14

## FIG.15

9/9

## FIG.16

## FIG.17

## FIG.18